# EUROPEAN PATENT APPLICATION

(11) **EP 4 614 565 A1**
(43) Date of publication of application: **10.09.2025**
(21) Application number: 23885448.3
(22) Date of filing: 05.10.2023
(51) Int. Cl.: H01L 23/473, B60R 16/02, F28F 3/04, H01L 25/07, H01L 25/18, H05K 7/20

(54) **COOLING MODULE**

(30) Priority: 31.10.2022 JP 2022174329
(71) Applicant: AISIN CORPORATION, Kariya-shi, Aichi 448-8650 (JP)
(72) Inventor: YAMAMOTO, Takeru, Kariya-shi, Aichi 448-8650 (JP); YAMADA, Yasutoshi, Kariya-shi, Aichi 448-8650 (JP); ISHII, Masato, Kariya-shi, Aichi 448-8650 (JP); YAMAGUCHI, Tomohiro, Kariya-shi, Aichi 448-8650 (JP); SASAKI, Sozaburo, Kariya-shi, Aichi 448-8650 (JP)
(74) Representative: Winter, Brandl - Partnerschaft mbB
(86) International application number: PCT/JP2023/036322
(87) International publication number: WO 2024/095685

(57) **Abstract**

A cooling module includes a substrate equipped with drivers that energize auxiliary machines mounted on a vehicle, and a module housing that holds the substrate, in which the module housing includes a channel housing in which a cooling channel through which a coolant flows is formed inside, and a heat conduction member is provided over the substrate and the cooling channel.

## Description

### TECHNICAL FIELD

The present invention relates to a cooling module that cools drivers that energize auxiliary machines mounted on a vehicle.

### BACKGROUND ART

Conventionally, various auxiliary machines (an electric pump, a valve device, and the like, for example) are mounted on the vehicle. Such auxiliary machines are energized by a driver. As a technique related to such an auxiliary machine and a driver, for example, there is a technique described in Patent Literature 1 of which source is described below.

Patent Literature 1 describes a motor drive device. The motor drive device includes a motor unit, a first cover member, a circuit board, a second cover member, and a heat conduction member. The motor unit is covered with a lid part included in the first cover member, and the circuit board is provided on an outer surface side of the first cover member. The circuit board functions as a control board that controls operation of the motor unit. Furthermore, of the circuit board, a heat generation element is mounted on a surface facing the motor unit, and the second cover member is provided on a surface opposite to the surface on which the heat generation element is mounted via the heat conduction member. A channel through which oil flows is formed on the outer surface side of the second cover member, and heat from the heat generation element mounted on the circuit board is dissipated to the oil via the heat conduction member and the second cover member.

### CITATIONS LIST

### PATENT LITERATURE

Patent Literature 1: JP 2022-78388 A

### SUMMARY OF INVENTION

### TECHNICAL PROBLEMS

In the motor drive device described in Patent Literature 1, a heat generation element mounted on the circuit board exchanges heat with the oil flowing on the outer surface side of a second cover member. However, because the second cover member is provided with projections having inside a space therein, cooling efficiency may decrease due to the space.

Therefore, a cooling module having an excellent cooling effect is required.

### SOLUTIONS TO PROBLEMS

A characteristic configuration of a cooling module according to the present invention is that the cooling module includes a substrate equipped with drivers that energize auxiliary machines mounted on a vehicle, and a module housing that holds the substrate, in which the module housing includes a channel housing in which a cooling channel through which a coolant flows is formed inside, and a heat conduction member is provided over the substrate and the cooling channel.

With such a characteristic configuration, the substrate, the heat conduction member, and the cooling channel are stacked, and downsizing is possible. Furthermore, because the heat conduction member is provided over the substrate equipped with the drivers and the cooling channel, heat generated in the drivers mounted on the substrate can be released to the coolant flowing through the cooling channel via the heat conduction member. Therefore, the drivers can be appropriately cooled, and the cooling module having an excellent cooling effect can be implemented.

### BRIEF DESCRIPTION OF DRAWINGS

FIG. 1 is a side-sectional view of a cooling module.
FIG. 2 is a top view of a substrate.
FIG. 3 is a perspective view of a heat sink.
FIG. 4 is a perspective view of the heat sink.
FIG. 5 is a perspective view of the heat sink.
FIG. 6 is a perspective view of the heat sink.
FIG. 7 is a perspective view of the heat sink.

### DESCRIPTION OF EMBODIMENTS

A cooling module according to the present invention is configured to be able to cool drivers mounted on a substrate. Hereinafter, a cooling module 1 of the present embodiment will be described.

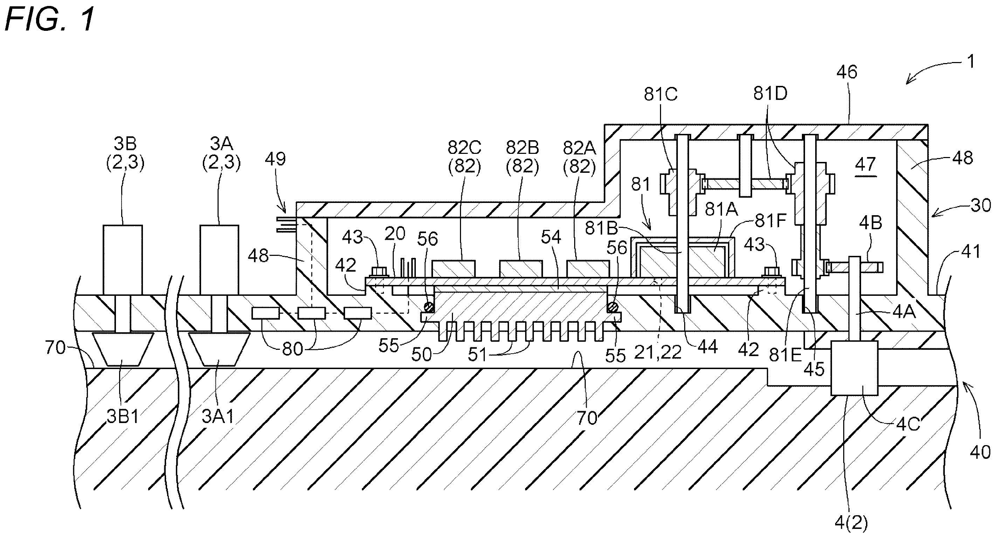

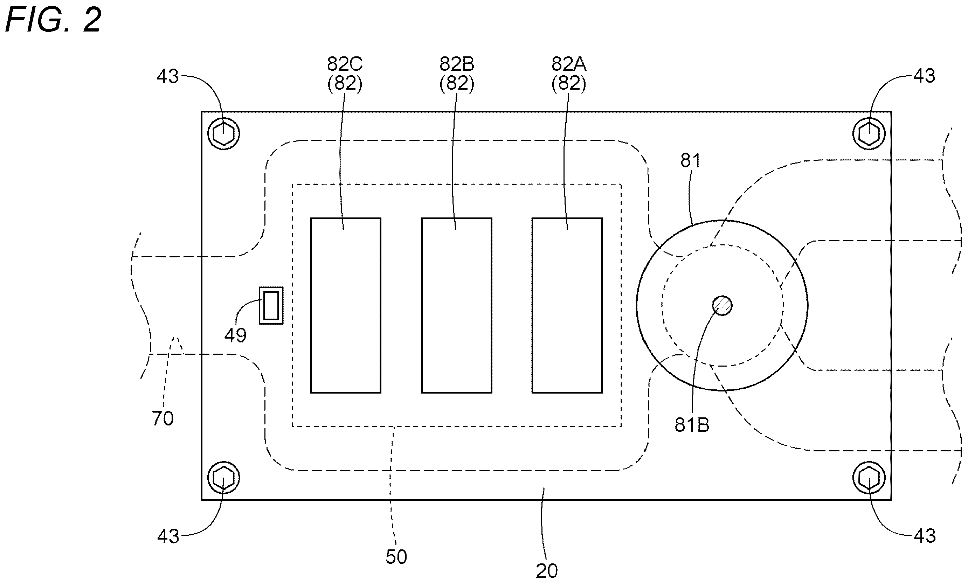

FIG. 1 is a side-sectional view of the cooling module 1. As shown in FIG. 1, the cooling module 1 includes a substrate 20, a module housing 30, and a heat sink (an example of a "heat conduction member") 50. FIG. 2 shows a top view of the substrate 20.

The substrate 20 is equipped with drivers 82 that energize auxiliary machines 2 mounted on the vehicle. The auxiliary machines 2 mounted on the vehicle are apparatuses that assist driving of a power source (an engine or a rotating electrical machine, for example) that moves (drives) a vehicle including the cooling module 1. Examples of such auxiliary machines 2 include an electric generator, a radiator, an oil pump, a water pump, motors for driving these pumps, a valve device, and the like. Such a plurality of auxiliary machines 2 are mounted on the vehicle, but in the present embodiment, water pumps 3 and a valve device 4 are included as the plurality of auxiliary machines 2.

Each of the water pumps 3 cause a coolant to flow through a cooling channel 70. For example, the cooling channel 70 is provided to communicate with a device other than a power source such as an engine or a rotating electrical machine and a power source such as an electric generator or a battery, and the coolant discharged from the water pump 3 is supplied through the cooling channel 70. The coolant is cooling water such as a long-life coolant (LLC), an insulating oil such as paraffin, or a refrigerant condensate such as hydrofluorocarbon (HFC) or hydrofluoroolefin (HFO). This makes it possible to cool a supply destination (the engine, the rotating electrical machine, the electric generator, the battery, or the like) of the coolant. In the present embodiment, two water pumps 3 are provided as shown in FIG. 1, and in a case where the water pumps 3 are distinguished from each other, one water pump 3 will be described as a water pump 3A, and another water pump 3 will be described as a water pump 3B.

The valve device 4 is configured to be able to adjust an amount of the coolant flowing through the cooling channel 70. As shown in FIG. 1, the valve device 4 is provided on the cooling channel 70. The valve device 4 may be provided to adjust an amount of the coolant sucked into the water pump 3 or switch channels, or may be provided to adjust an amount of the coolant discharged from the water pump 3 or switch the channels. In the present embodiment, the valve device 4 is provided on the cooling channel 70 on which the water pump 3A is provided.

In the present embodiment, as shown in FIG. 1, the substrate 20 is provided with a motor 81 that drives the valve device 4. In the present embodiment, a gear 81C is provided at one end of a rotary shaft 81B of a rotor 81A of the motor 81. A gear 81D that reduces rotational speed of the motor 81 is provided so as to mesh with the gear 81C, and the gear 81D and a gear 4B provided on a rotary shaft 4A of the valve device 4 mesh with each other. This makes it possible for the motor 81 to drive the valve device 4.

Furthermore, the motor 81 is provided such that another end of the rotary shaft 81B penetrates the substrate 20, and the motor 81 is supported by the substrate 20 through a motor housing 81F. The motor housing 81F and the substrate 20 may be fastened and fixed by using, for example, a bolt, or may be fixed by another method. Furthermore, the motor 81 and the substrate 20 can be electrically connected by inserting a press-fit 22 into a through hole 21 provided in the substrate 20.

The drivers 82 energize the motor 81 and the water pump 3. The motor 81 in the present embodiment drives the valve device 4. Therefore, the drivers 82 energizes the motor 81 to operate the valve device 4. As with an H-bridge, a three-phase inverter, or the like, the drivers 82 can include, for example, a plurality of arm portions having a high-side switching element and a low-side switching element that are formed by being connected to each other in series.

An operation command is transmitted from a control unit (not shown) to each of the drivers 82. The operation command includes, for example, a command value of rotational speed, an output torque or the like, and the drivers 82 are controlled on the basis of such a command value. As a result, current having a current value corresponding to the command value flows from the drivers 82 to a coil of the motor 81 that drives the valve device 4 or coils of motors (not shown) included in the water pump 3.

In the present embodiment, the substrate 20 is equipped with a plurality of drivers 82 for energizing each of the plurality of auxiliary machines 2. FIG. 1 shows, as the drivers 82, a driver 82A that energizes the motor 81, a driver 82B that energizes the motor of the water pump 3A, and a driver 82C that energizes the motor of the water pump 3B.

In the present embodiment, the substrate 20 is equipped with the motor 81, the driver 82A, the driver 82B, and the driver 82C. The driver 82A, the driver 82B, and the driver 82C include switching elements, and terminals of the switching elements can be fixed by solder welding to lands provided on the substrate 20. Of course, the terminals of the switching elements can be inserted into and fixed to through holes provided in the substrate 20.

Furthermore, the substrate 20 may be equipped with a control unit (not shown) that controls at least one of the plurality of drivers 82. In a case where the motor 81 and the water pump 3 are driven by PWM control, the control unit that controls at least one of the plurality of drivers 82 corresponds to, for example, a PWM control unit. The control unit is not limited to the PWM control unit, and may be, for example, a power feed control unit that is provided at an input stage of the drivers 82 and is able to shut off power supplied to the drivers 82.

Such a substrate 20 includes a rigid substrate from a viewpoint of heat dissipation and load bearing. In particular, the substrate 20 can be implemented at low cost by using a printed circuit board.

The module housing 30 holds the substrate 20. The module housing 30 is made of, for example, resin. The module housing 30 has a channel housing 40 to be described later. The substrate 20 is held on an outer surface 41 of the channel housing 40. A projection 42 protruding from the outer surface 41 of the channel housing 40 is provided on the outer surface 41, and the substrate 20 is fastened and fixed with bolts 43, in a state of being placed on the projection 42. Furthermore, although the gear 81C is provided at one end of the rotary shaft 81B of the motor 81 as described above, another end of the rotary shaft 81B is supported with bearing, in a state of being inserted into a recess 44 formed in the outer surface 41. Moreover, in the present embodiment, a rotary shaft 81E of the gear 81D is also supported with bearing, in a state of being inserted into a recess 45 formed in the outer surface 41.

Moreover, a plurality of wall portions 48 erected from the outer surface 41 are formed in the channel housing 40, and a top plate 46 is supported over the plurality of wall portions 48. As a result, the substrate 20 is housed in a space 47 surrounded by the channel housing 40, the wall portions 48, and the top plate 46. Furthermore, busbars 80 are insert-molded in the channel housing 40, and power is supplied from busbars 80 to a predetermined land of the substrate 20 via press-fitting. In the example in FIG. 1, a wiring line electrically connected to the busbars 80 is provided inside the wall portions 48, and a connector part 49 is formed so as to protrude to a side opposite to the space 47 in the wall portions 48. This makes it possible to extract power from the busbars 80 via the connector part 49.

In the present embodiment, the module housing 30 holds the water pump 3A, the water pump 3B, and the valve device 4, in addition to the substrate 20. In the present embodiment, the water pump 3A and the water pump 3B are provided such that a vane part 3A1 and a vane part 3B1 are positioned on a cooling channel 70 side in the module housing 30, and that the valve device 4 is provided such that a valve part 4C is positioned on a cooling channel 70 side in the module housing 30.

The cooling channel 70 described above is formed inside the channel housing 40, and the coolant flows through the cooling channel 70. The channel housing 40 is made of resin, and the cooling channel 70 can be formed, for example, on a split surface by drilling.

A heat sink 50 is provided over the substrate 20 and the cooling channel 70. In the present embodiment, one side of the heat sink 50 is attached to the substrate 20 via a gap filler 54, and another side of the heat sink 50 is provided in a state of being exposed to the cooling channel 70. As shown in FIG. 2, the heat sink 50 is preferably attached to, for example, a back side of an area on the substrate 20, on which the drivers 82 are mounted. Furthermore, at least at a portion where the cooling channel 50 overlaps the heat sink, the cooling channel 70 is preferably wider outward than the heat sink 50 when the substrate 20 is viewed from above. That is, the cooling channel 70 is preferably configured such that the heat sink 50 overlaps the cooling channel 70 when the substrate 20 is viewed from above. As a result, heat from the drivers 82 can be easily transferred to the heat sink 50. Note that a flange portion 55 of the heat sink 50 is preferably provided with a seal member 56 (for example, an O-ring).

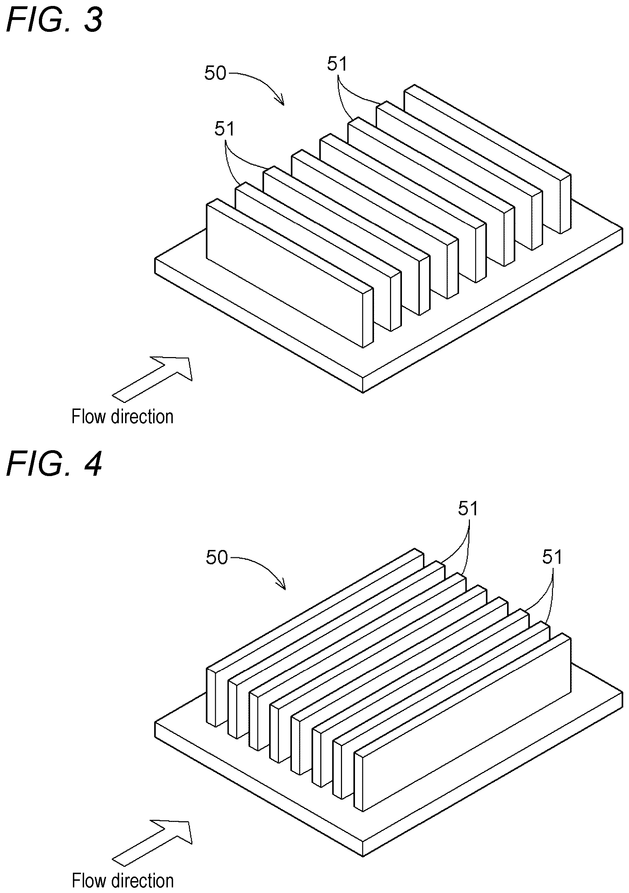

In the present embodiment, the heat sink 50 is provided in the channel housing 40 and includes fins 51 erected toward an inside of the cooling channel 70. As a result, the heat sink 50 to which the heat from the drivers 82 is transferred can be directly cooled by the coolant flowing through the cooling channel 70. Therefore, the drivers 82 can be cooled more efficiently. The heat sink 50 may be configured as shown in FIG. 3 such that the fins 51 are erected in a state of intersecting (preferably being orthogonal to) a direction in which the coolant flows through the cooling channel 70, or may be configured as shown in FIG. 4 such that the fins 51 are erected in a state of being parallel to the direction in which the coolant flows through the cooling channel 70.

Such a heat sink 50 can be integrally molded with the module housing 30. **In** this case, the heat sink 50 can face the cooling channel 70 in a state where the module housing 30 and the channel housing 40 are joined.

As described above, by providing the heat sink 50 over the substrate 20 equipped with the driver 82 and the cooling channel 70 formed inside the channel housing 40, the drivers 82 can be appropriately cooled. Furthermore, the cooling module 1 can be downsized, because appropriate cooling is possible even in a case where the plurality of drivers 82 are provided on the substrate 20.

### [Other embodiments]

Next, other embodiments of a cooling module 1 will be described.

In the above embodiment, it has been described that the substrate 20 is equipped with the plurality of drivers 82. However, the number of drivers 82 mounted on the substrate 20 may be one.

In the above embodiment, it has been described that the substrate 20 is equipped with the control unit that controls at least one of the plurality of drivers 82. However, the substrate 20 may not be equipped with the control unit.

In the above embodiment, it has been described that the auxiliary machines 2 include the water pump 3 and the valve device 4. However, the auxiliary machines 2 may include either the water pump 3 or the valve device 4, or the auxiliary machines 2 may not include both the water pump 3 and the valve device 4.

In the above embodiment, it has been described that the substrate 20 is supported by the outer surface 41 of the channel housing 40. However, the substrate 20 may be supported at a portion different from the outer surface 41 of the channel housing 40, or may be supported in a state of being separated from the outer surface 41, for example.

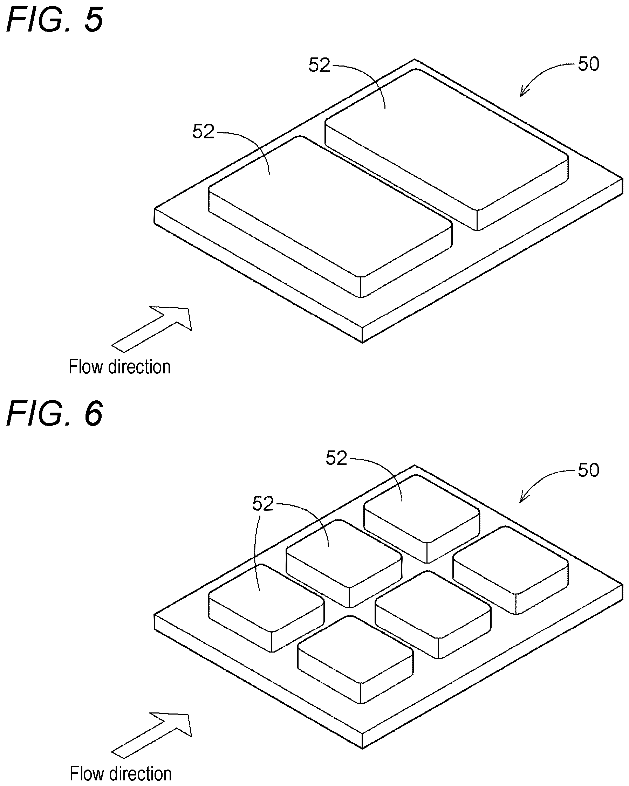

In the above embodiment, it has been described that the heat sink 50 includes the fins 51 erected toward the inside of the cooling channel 70. However, as shown in FIG. 5, the heat sink 50 may include plate-like members 52 exposed to an inside of the cooling channel 70. Furthermore, in FIG. 5, the heat sink 50 is shown as including two plate-like members 52, but the number of the plate-like members 52 can be set according to pressure resistance and heat exchange efficiency of the heat sink 50 with respect to a coolant flowing through the cooling channel 70. Specifically, as shown in FIG. 5, the number of the plate-like members 52 can be reduced so that the heat exchange efficiency increases although the pressure resistance increases, or as shown in FIG. 6, the number of the plate-like members 52 can be increased so that the pressure resistance decreases although heat conversion efficiency decreases. Furthermore, although not shown, the number of the plate-like members 52 may be one.

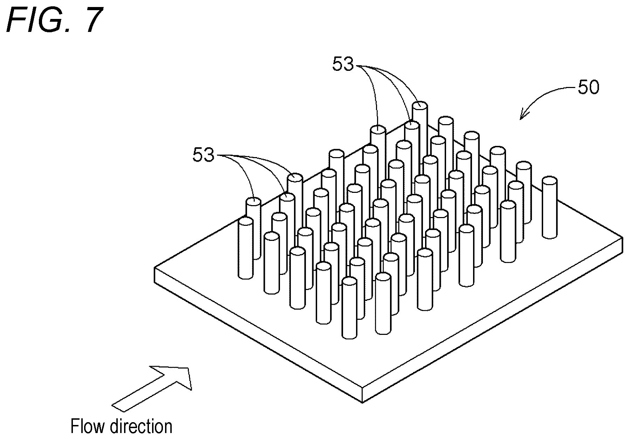

Furthermore, for example, as shown in FIG. 7, the heat sink 50 can include a plurality of pins 53 instead of the fins 51. The fins 51, the plate-like members 52, and the pins 53 may be combined, or may be arranged with different heights.

In the above embodiment, the heat sink 50 has been described as an example of a heat conduction member, but the heat conduction member is only required to be any member that conducts heat and may not be the heat sink 50.

### [Overview of above embodiments]

Hereinafter, an overview of the cooling module 1 described above will be described.
(1) A cooling module 1 includes a substrate 20 equipped with drivers 82 that energizes an auxiliary machine 2 mounted on a vehicle, and a module housing 30 that holds the substrate 20, in which the module housing 30 includes a channel housing 40 in which a cooling channel 70 through which a coolant flows is formed inside, and a heat sink (heat conduction member) 50 is provided over the substrate 20 and the cooling channel 70.
   According to this configuration, the substrate 20, the heat sink 50, and the cooling channel 70 are stacked, and downsizing is possible. Furthermore, because the heat sink 50 is provided over the substrate 20 equipped with the drivers 82 and the cooling channel 70, heat generated in the drivers 82 mounted on the substrate 20 can be released to the coolant flowing through the cooling channel 70 via the heat sink 50. Therefore, the drivers 82 can be appropriately cooled, and the cooling module 1 having an excellent cooling effect can be implemented.
(2) **In** the cooling module 1 according to (1), the heat sink 50 is preferably integrally molded with the module housing 30, and preferably faces the cooling channel 70 in a state where the module housing 30 and the channel housing 40 are joined.
   According to this configuration, the heat sink 50 can be easily fitted to the cooling channel 70.
(3) In the cooling module 1 according to (1), the substrate 20 is preferably equipped with the plurality of drivers 82 that energize each of the plurality of auxiliary machines 2, and is preferably further equipped with a control unit that controls at least one of the plurality of drivers 82.
   According to this configuration, the plurality of drivers 82 collectively mounted on the substrate 20 can be cooled. Furthermore, because the drivers 82 and the control unit that controls the drivers 82 can be mounted close to each other on the substrate 20, downsizing is possible, including downsizing of the control unit.
(4) In the cooling module 1 according to (3), the plurality of auxiliary machines 2 preferably include a water pump (pump) 3 that causes the coolant to flow through the cooling channel 70, and a valve device 4 that is able to adjust an amount of the coolant flowing through the cooling channel 70 or switching channels, and the substrate 20 is preferably supported by an outer surface 41 of the channel housing 40.
   According to this configuration, for example, the drivers 82 that drive the water pump 3 and the valve device 4, and the motor that drives these can be cooled by utilizing the coolant that flows by the water pump 3 and the valve device 4. Therefore, it is not necessary to separately provide a structure for cooling the drivers 82, downsizing is possible.
(5) In the cooling module 1 according to any one of (1) to (4), the heat sink 50 preferably includes fins 51 erected toward an inside of the cooling channel 70.
   According to this configuration, the fins 51 can be brought into contact with the coolant flowing through the cooling channel 70. Therefore, because the fins 51 to which heat from the substrate 20 is transmitted can be directly cooled by the coolant, cooling efficiency can be further enhanced.
(6) In the cooling module 1 according to any one of (1) to (4), the heat sink 50 may include plate-like members 52 exposed to an inside of the cooling channel 70.

According to this configuration, the plate-like members 52 can be brought into contact with the coolant flowing through the cooling channel 70. Therefore, because the plate-like members 52 to which heat from the substrate 20 is transmitted can be directly cooled by the coolant, cooling efficiency can be further enhanced. Furthermore, because it is only required to provide the plate-like members 52 on the heat sink 50, processing is easy.

### INDUSTRIAL APPLICABILITY

The present invention can be used for a cooling module that cools drivers that energize auxiliary machines mounted on a vehicle.

### REFERENCE SIGNS LIST

1: Cooling module, 2: Auxiliary machine, 3: Water pump (pump), 4: Valve device, 20: Substrate, 30: Module housing, 40: Channel housing, 41: Outer surface, 50: Heat sink (heat conduction member), 51: Fin, 52: Plate-like member, 70: Cooling channel, and 82: Driver

## Claims

1. A cooling module comprising:
a substrate equipped with drivers that energize auxiliary machines mounted on a vehicle; and
a module housing that holds the substrate, wherein
the module housing includes a channel housing in which a cooling channel through which a coolant flows is formed inside, and
a heat conduction member is provided over the substrate and the cooling channel.

2. The cooling module according to claim 1, wherein the heat conduction member is integrally molded with the module housing, and faces the cooling channel in a state where the module housing and the channel housing are joined.

3. The cooling module according to claim 1, wherein the substrate is equipped with a plurality of the drivers that energize each of a plurality of the auxiliary machines, and is further equipped with a control unit that controls at least one of a plurality of the drivers.

4. The cooling module according to claim 3, wherein
a plurality of the auxiliary machines include a pump that causes the coolant to flow through the cooling channel, and a valve device that is able to adjust an amount of the coolant flowing through the cooling channel or switching channels, and
the substrate is supported by an outer surface of the channel housing.

5. The cooling module according to any one of claims 1 to 4, wherein the heat conduction member includes a fin erected toward an inside of the cooling channel.

6. The cooling module according to any one of claims 1 to 4, wherein the heat conduction member includes a plate-like member exposed to an inside of the cooling channel.
